# EUROPÄISCHE PATENTANMELDUNG

(11) **EP 0 624 827 A1**
(43) Veröffentlichungstag der Anmeldung: **17.11.1994**
(21) Anmeldenummer: 94810254.6
(22) Anmeldetag: 03.05.1994
(51) Int. Cl.: G03F 7/075, G03F 7/36, C07F 7/18, C07F 7/08

(54) **Verfahren zur Herstellung von Mikrostrukturen**

(30) Priorität: 12.05.1993 CH 1468/93
(71) Anmelder: CIBA-GEIGY AG, CH-4002 Basel (CH)
(72) Erfinder: Schädeli, Ulrich, Dr., CH-1737 Plasselb (CH)

(57) **Zusammenfassung**

Verfahren zur Herstellung von Mikrostrukturen auf einem Substrat durch Bildung eines Resistfilmes auf dem Substrat und Belichtung des Resistfilmes durch eine Maske, dadurch gekennzeichnet, dass der Resistfilm eine ätzbarrierebildende Substanz enthält, welche bei der Belichtung an den belichteten Zonen des Resistfilmes zum Aufbau eines Metall- Gradienten führt, und dass man anschliessend den belichteten Resistfilm mit einem Sauer- stoffplasma entwickelt, wobei die unbelichteten Stellen des Resistfilms weggeätzt werden, sowie eine Resistlösung, welche
a) ein Matrix Polymer, das mindestens ein aromatisches Strukturelement aufweist,
b) eine unter aktinischer Strahlung Säure oder Radikale freisetzende Verbindung,
c) eine retardierbare ätzbarrierebildende Substanz,
d) ein Lösungsmittel, und
e) gegebenenfalls weitere Zusatzstoffe enthält, als auch die Verwendung der Resistlösung zur Herstellung von Halbleiterbausteinen in der Microelektronik. Das Verfahren ermöglicht die Einbringung der ätzbarrierebil- denden Substanz mit der Resistlösung und ergibt eine getreue Übertragung der Maske auf das Substrat.

## Beschreibung

Die vorliegende Erfindung betrifft ein neues Verfahren zur Herstellung von Mikrostrukturen durch Belichtung eines Resistfilmes auf einem geeigneten Substrat, wobei der Film eine ätzbarrierebildende Substanz enthält, ferner eine Resistlösung, die den Resistfilm bildet, und die gemäss dem neuen Verfahren erhaltenen Mikrostrukturen sowie die Verwendung dieser Mikrostrukturen vor allem in der Mikrolithographie zur Herstellung von Halbleiterbausteinen und Speicherchips für die Mikroelektronik.

Die Spitzentechnik wird heutzutage von einem Trend hin zu Bausteinen mit immer höherer Integrationsdichte beherrscht. Dies trifft insbesondere für die Mikroelektronik zu. Während beim 256 Kbit Speicherchip (DRAM) pro Informationseinheit (Bit) noch eine Fläche von ca. 70 g_{M}² benötigt wurde, begnügte sich die nächste Generation (1 Mbit) lediglich mit ca 20 wm². In den heute in der Massenproduktion hergestellten 4 Mbit Speicherchips werden pro Bit noch ca. 10 µm² beansprucht, beim um die Jahrtausendwende erwarteten 1 Gbit Chip werden es dann lediglich noch ca. 1,5 g_{M}² sein.

Die in der Technik heute vorwiegend eingesetzten Materialien ergeben ein positives Abbild der Maske, d.h. belichtete Zonen des Resistfilmes werden nach der Belichtung in einem wässrig-alkalischen Entwickler löslich, während die unbelichteten Zonen auf dem Substrat zurückbleiben. Solche Materialien arbeiten auf der Basis von Diazonaphtochinonen, welche unter der Einwirkung von Strahlung in Carbonsäuren überführtwerden (siehe z.B. Photoreactive Polymers "The Science and Technology of Resists", Arnost Reiser, Institute of Imaging Sciences, Polytechnic University Brooklyn, New York, - A Wiley Interscience Publication John Wiley & Sons, Seiten 178-182). Der damit einhergehende Polaritätsunterschied bewirkt eine Löslichkeitsdiskriminierung in geeigneten Entwicklern. Dabei werden die Profile der derart erzeugten Resiststrukturen in der Weise beeinflusst, dass das Licht durch den Resistfilm gelangt. Da die Schichtdicke des Resistfilms in der Grössenordnung um 1 µm liegt, die zu erzielenden Strukturen andererseits bereits heute Dimensionen von unterhalb von 0,5 µm aufweisen, wird verständlich, dass die einfallende Strahlung nicht durch den ganzen Resistfilm hindurch voll im Fokus sein kann. Im Weitern verliert das einfallende Licht bei der Durchquerung des Resistfilms an Intensität, hervorgerufen durch die Absorption des Photoresists. Dies hat zur Folge, dass die unteren Zonen des Resistfilms weniger stark belichtet werden als die oberen. Ferner wird die Strahlung von der normalerweise hochpolierten Substratoberfläche reflektiert, was Streueffekte bewirkt. Ein Nachteil dieses Verfahrens ist daher, dass die Resistprofile häufig nicht exakt senkrechte Kanten aufweisen, die in der Technik gefordert werden, sondern abgerundet (barrel shaped) oder keilförmig (lift-off) sind, d.h. die Strukturen der Maske können nicht getreu auf das Substrat übertragen werden.

Eine Möglichkeit zur Vermeidung der oben erwähnten Probleme besteht darin, die Photochemie nur in der obersten Schicht eines hochabsorbierenden Photoresistfilms ablaufen zu lassen. In dieser Oberflächenbelichtungstechnik wird das einfallende Licht in den obersten Zonen des Resistfilms vollständig absorbiert und kann nicht in tieferliegende Zonen vordringen. Die in den oberen Zonen durchgeführte Photochemie ermöglicht den Aufbau einer Aetzbarriere, welche normalerweise aus einer geeigneten Form von Silizium besteht. Die Uebertragung der Maskenstrukturen runter auf das Halbleitersubstrat wird anschliessend in einem gerichteten Sauerstoffplasma durchgeführt.

In der Literatur sind mehrere Techniken beschrieben, welche nach diesem Prinzip arbeiten. Am Anfang standen die Mehrschichtverfahren, bei welchen ein sitiziumhattigerResist auf ein geeignetes Planarisierungsharz aufgetragen wurde [siehe z.B. "Heat developable resist for multilayer resist technology" von Alfred Steinmann in SPIE Vol. 920 Advances in Resist Technology and Processing V (1988), S. 13-20; "Highly sensitive thermally developable positive resist systems" v. Hiroshi Ito, Mitsuru Ueda and Reinhold Schwalm in J. Vac. Sci. Technol. B 6 (6), Nov/Dec 1988, S. 2259-2263; "Polysilanes for Mikrolithography" v. G.M. Wallraff, R.D. Miller, N. Clecak and M. Baier, in SPIE Vol. 1466 Advances in Resist Technology and processing VIII (1991), S. 211-216]. Ein Nachteil dieser Verfahren besteht darin, dass das Auftragen von mehr als einer Resistschicht eine unerwünschte Erhöhung des Arbeitsaufwandes darstellt, so dass schon bald versucht wurde, mit nur einer Photoresistschicht auszukommen.

Ein System dieser Art basiert auf dem Desire-Prozess, wo die Aetzbarriere nach der Belichtung des Resistfilms durch Dampfphasensilylierung eingebracht wird [siehe z.B.: DESIRE: "A novel dry developed resist system", v. Fedor Coopmans und Bruno Roland in SPIE Vol. 631 Advances in Resist Technology and Processing 111 (1986), S. 34-39, und "Surface Imaging Techniques"v. B. Roland in Mikroelectronic Engineering 13(1991), S. 11-18]. Das System arbeitet jedoch nicht nach dem Prinzip der chemischen Verstärkung (wie z.B. beschrieben in "Chemical Amplification in the Design of Dry Developing Resist Materials" v. Hiroshi Ito und C. Grant Willson in Polymer Engineering and Science, December 1983, Vol. 23, S. 1012-1018) und ist daher nur relativ unempfindlich. In einem neueren, chemisch amplifizierten System wird durch Belichtung in den obersten Zonen des Resistfilms eine starke Broensted-Säure erzeugt, welche danach als Katalysator zur Freisetzung von Phenolen dient. Auch hier wird die Aetzbarriere anschliessend durch Dampfphasen- oder Flüssigsilylierung eingeführt ("Vapor Phase Photoresist Silylation Process" by Steven J. Holmes, US Pat. 4,808,511). Ein weiterer Ansatz basiert auf der Erzeugung einer Aetzbarriere durch "electroless deposition" eines geeigneten Metalls an der Resistoberfläche (New Surface Imaging Techniques for Sub-0,5 Micrometer Optical Lithography, by J.M. Calvert, C.S. Dulcey, M.C. Peckerar, J.M. Schnur in Solid State Technology, Okt. 1991, S. 77-82). Wegen der Kompliziertheit dieses Verfahrens (viele Prozessschritte) sowie der Verwendung von nicht unbedenklichen Metallen (z.B. Dotierungsgefahr am Halbleitersubstrat) ist dieses Verfahren technisch nicht besonders geeignet. Weitere Ansätze beruhen auf der Bestrahlung von Resistoberflächen mit hochenergetischem 193-nm Laserlicht. Damit kann einerseits eine Vernetzung der Resistoberfläche in den bestrahlten Zonen erreicht werden, was eine Verminderung der Aufnahmefähigkeit des Silylierungsmittels bewirkt ("Evaluation of Phenolic Resists for 193-nm Surface Imaging", by Mark A. Hartney, Donald W. Johnson und Allen C. Spencer, in SPIE Vol. 1466 Advances in Resist Technology and Processing VIII (1991), S. 238-247). Lithographie bei 193-nm ist jedoch wegen der hohen optischen Absorption der dabei eingesetzten Materialien (Optik, Resist) nicht unproblematisch.

All diesen letztgenannten Systemen für die Oberflächenbelichtung ist gemeinsam, dass die Aetzbarriere erst nach der Belichtung von aussen mittels einer Gasphasen- oder Nass-Silylierung eingeführt wird. Dies stellt zusammenfassend jedoch erhebliche Nachteile dar: um reproduzierbare Ergebnisse zu erhalten, müssen z.B. die Prozessparameterwährend der Silylierungsphase genauestens kontrolliert werden können, was in der Praxis mit erheblichem technischem Aufwand und nur schwierig realisiert werden kann. Ferner stellt die nachträgliche Silylierung einen zusätzlichen, zeitaufwendigen und kostspieligen Prozessschritt dar.

Aufgabe der Erfindung war es daher, einerseits ein Verfahren zur Herstellung von Mikrostrukturen zu entwickeln, welches die aufgezeigten Nachteile überwindet und welches die Aetzbarriere nicht von aussen einführt, um ein wirtschaftlicheres Verfahren zurVerfügung zu stellen, und andererseits ein Einlagenresistsystem für eine Oberflächenbelichtung zur Verfügung zu stellen, welches die Komponente(n) zur Erzeugung der Aetzbarriere bereits eingebaut hat.

Ein Gegenstand der vorliegenden Erfindung ist demnach ein Verfahren zur Herstellung von Mikrostrukturen auf einem Substrat durch Bildung eines Resistfilmes auf diesem Substrat und Belichtung des Resistfilmes durch eine Maske, dadurch gekennzeichnet, dass der Resistfilm eine ätzbarrierebildende Substanz enthält, welche bei der Belichtung an den belichteten Zonen des Resistfilmes zum Aufbau eines Metall-Gradienten führt und dass man anschliessend den behandelten Resistfilm mit einem Sauerstoffplasma entwickelt, wobei die unbelichteten Stellen des Resistfilmes weggeätzt werden.

Ein weiterer Gegenstand der vorliegenden Erfindung stellt eine neurartige Resistlösung dar, welche den Resistfilm bildet, welche eine neue Zusammensetzung enthaltend Siliziumverbindungen als "Aetzbarriere" umfasst.

Es war überraschend, dass ein solch einfaches Verfahren trotz komplexer Chemie ohne irgendwelche nachteiligen Effekte gut durchführbar ist. Ausserdem hat das erfindungsgemässe Verfahren gegenüber dem Stand der Technik einen Prozessschritt weniger.

Die Resistlösung, welche photoaktiv sein muss und einen weiteren Gegenstand dieser Erfindung darstellt, enthält:
a) ein Matrix Polymer, das mindestens ein aromatisches Strukturelement aufweist,
b) eine unter aktinischer Strahlung Säure oder Radikale freisetzende Substanz, d.h. einen Photo-Säure-und/oder Photo-Radikalbildner,
c) eine retardierbare ätzbarrierebildende Substanz,
d) ein Lösungsmittel, und
e) gegebenenfalls weitere Zusatzstoffe.

Um sicherzustellen, dass das einfallende Licht weitgehend in den obersten Zonen des Resistfilms absorbiert wird, muss die optische Dichte des Restfilms bei der verwendeten Lichtwellenlänge einen Wert von vorzugsweise mindestens 1,0 aufweisen. Dies kann durch Verwendung eines hochabsorbierenden Bestandteils a), b) oder c), oder auch durch Zugabe eines hochabsorbierenden Additivs als Zusatzstoff e) erreicht werden.

Als Matrix Polymer a), das mindestens ein aromatisches Strukturelement aufweist, kommen alle filmbildenden makromolekularen Substanzen in Frage, wie z.B.:
i) Novolake aus mindestens einem Phenol und mindestens einem Aldehyd,
ii) Homo- und Copolymere von Alkenylphenolen,
iii) Homo- und Copolymere von Styrolen,
iv) Homo- und Copolymere von N-Hydroxyphenylmaleinimiden oder N-Phenylmaleinimiden,
v) Homo- und Copolymere von Phenylmethacrylaten und Phenylacrylaten.

Novolake i) sind z.B. Verbindungen, die sich von einem C₁-Cₛ-Aldehyd, beispielsweise Formaldehyd oder Acetaldehyd, und von einem zweikernigen, bevorzugt jedoch einkernigen, gegebenenfalls substituierten Phenol ableiten. Beispiele für bevorzugte Phenole sind Phenol selbst oder mit einer oder zwei Cᵢ-Cg-Aikyigruppen substituierte Phenole, wie beispielsweise o-, m- oder p-Kresol, Xylenol, p-tert.Butylphenol und o-, m- oder p-Nonylphenol, oder mit einem oder zwei Halogenatomen, bevorzugt Chlor oder Brom, substituierte Phenole, beispielsweise p-Chlorphenol, ferner mit einem Phenylkern substituierte Phenole, wie z.B. p-Phenylphenol, oder auch Phenole mit mehr als einer phenolischen Gruppe, wie z.B. Resorcin, Bis-(4-hydroxyphenyl)methan oder 2,2-Bis-(4-hydroxyphenyl)propan.

Homo- und Copolymere von Alkenylphenolen ii) sind insbesondere solche mit wiederkehrenden Strukturelementen der Formel 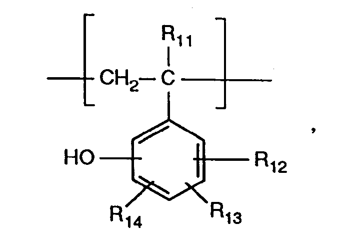
worin R₁₁ Wasserstoff oder Methyl ist, R₁₂, R₁₃ und R₁₄ unabhängig voneinander Wasserstoff, C₁-C₄-Alkyl, C₁-C₄-Alkoxy, Halogen, insbesondere Chlor oder Brom, oder Methylol bedeuten. Die phenolische Hydroxylgruppe ist in o-, m- oder p-Stellung zurAlkenylgruppe angeordnet, bevorzugt jedoch in p-Stellung.

Als Comonomere für die Herstellung der obigen Copolymere ii kommen beispielsweise carboxylgruppenfreie Vinylmonomere in Betracht. Beispiele für solche Monomere sind Styrol, Acryl- und Methacrylsäureester, insbesondere (Meth)acrylsäuremethylester oder (Meth)acrylsäure-2-hydroxyethylester, Acrylamid, Vinylacetat und N-substituierte Maleinimide.

Der Comonomerenanteil beträgt bevorzugt 0-50 Mol%, bezogen auf das Gesamtpolymere.

Polymere des Typs ii) sind bekannt und beispielsweise in der DE-A 2 322 230 und in der EP-A 153,682 beschrieben. Teilweise sind solche Polymere auch im Handel erhältlich.

Materialien des Typs iii) können Homopolymere von Styrol, Hydroxystyrol oder dessen Copolymere mit Maleinsäureanhydrid oder Maleinimiden der Formel

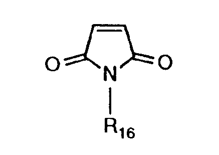

sein,
worin R₁₆ ein C₁-C₁₀-Alkyl, C₁-C₁₀-Hydroxyalkyl oder Aryl bedeutet:

Matrix Polymere des Typs iv) sind z.B. Homopolymere von N-Hydroxyphenylmaleinimiden. Dabei handelt es sich bevorzugt um Homopolymere mit der Struktureinheit der Formel 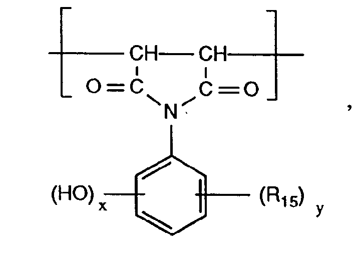
worin R₁₅ C₁-C₄-Alkyl, C₁-C₄-Alkoxy oder Halogen, insbesondere Chlor oder Brom ist, x die Zahl 1, 2 oder 3 darstellt, y 0, 1, 2, 3 oder4 ist und die Summe von x und y höchstens 5 bedeutet, wobei die Reste R₁₅ im Phenylkern innerhalb der gegebenen Definitionen unterschiedlich sein können.

Bedeuten R₁₂, R₁₃, R₁₄ oder R₁₅ C₁-C₄-Alkyl, so handelt es sich dabei um geradkettige oder verzweigte, bevorzugt um geradkettige Alkylreste. Beispiele für solche Gruppen sind Methyl, Ethyl, n-Propyl, Isopropyl, n-Butyl oder sek.Butyl. Bevorzugt ist Methyl.

Als C₁-C₄-Alkoxy besitzt der Alkylteil von R₁₂, R₁₃, R₁₄ oder R₁₅ die oben beispielhaft erwähnten Bedeutungen. Bevorzugt ist Methoxy.

R₁₆ als C₁-C₁₀-Alkyl ist z.B. Methyl, Ethyl, n-Propyl, Isopropyl, n-Butyl, n-Pentyl, n-Hexyl, n-Octyl oder n-Decyl. R₁₆ als C₁-C₁₀-Hydroxyalkyl sind z.B. die gleichen oben für R₁₆ angegebenen Alkylreste, die zusätzlich mit einer Hydroxylgruppe substituiert sind, insbesondere Hydroxymethyl. R₁₆ als Aryl ist z.B. Phenyl oder Naphthyl, welche z.B. durch Methyl, Methoxy oder Halogen ein- oder mehrfach substituiert sein können.

Als Halogen sind R₁₂, R₁₃, R₁₄, R₁₅ oder R₁₆ Fluor, Chlor, Brom oder lod. Bevorzugt ist Chlor oder Brom, insbesondere Brom.

Der Index im Strukturelement der obigen Formel ist vorzugsweise 1 oder 2, besonders bevorzugt 1. Der Index y ist vorzugsweise 0, 1 oder 2, bevorzugt aber 0.

N-Phenylmaleinimide sind insbesondere solche mit wiederkehrenden Strukturelementen der vorstehenden Formel, wobei die Phenyleinheit keine Hydroxygruppe enthält.

Eine weitere bevorzugte Gruppe von Matrix Polymeren des Typs iv) sind Copolymere auf der Basis von N-Hydroxyphenylmaleinimiden, insbesondere solche mit letzteren, obigen Strukturelementen und carboxylgruppenfreien Verbindungen.

Beispiele für geeignete Vinyl-Comonomere sind:
A) Styroltypen, wie beispielsweise Styrol, a-Methylstyrol, p-Methylstyrol oder p-Hydroxystyrol;
B) Ester oder Amide von a,ß-ungesättigten Säuren, wie beispielsweise Acrylsäuremethylester, Acrylsäureamid, die entsprechenden Methacrylverbindungen oder Maleinsäuremethylester;
C) Nitrile von a,ß-ungesättigten Säuren, wie beispielsweise Acrylnitril oder Methacrylnitril;
D) halogenhaltige Vinylverbindungen, wie beispielsweise Vinylchlorid, Vinylfluorid, Vinylidenchlorid oder Vinylidenfluorid;
E) Vinylester, wie beispielsweise Vinylacetat oder
F) Vinylether, wie beispielsweise Methylvinylether oder Butylvinylether.

DerAnteil derVinyl-Comonomerenkomponente beträgt in der Regel 0 bis 95 Mol%, bevorzugt 0-75 Mol%, besonders bevorzugt 0-50 Mol%, bezogen auf den Gesamtanteil an Monomereinheiten.

Homopolymere aus Struktureinheiten der obigen, letzten Formel (N-Hydroxyphenylmaleinimide) und Copolymere mit Vinylverbindungen sind bekannt und werden beispielsweise in der BE-A 613,801 sowie in Kobunshi Kagaku 26, 593-601 (1969) (Chem. Abstr. 72, 21964n) beschrieben.

Eine weitere besonders bevorzugte Gruppe von Matrix Polymere des Typs iv) sind Copolymere auf der Basis von N-Hydroxymaleinimiden, Allylverbindungen und gegebenenfalls weiteren Vinylverbindungen.

Weitere Matrix Polymere des Typs iv) sind in der EP-A 0 255 989 beschrieben.

Matrix Polymere des Typs v) sind z.B. Homo- oder Copolymere von Phenylestern der Acrylsäure oder der Methacrylsäure. Als Comonomere kommen in Frage: Acrylsäure oder deren Ester, Methacrylsäure oder deren Ester, Styrole oder Hydroxystyrole.

Besonders bevorzugt verwendet man als Matrix Polymer ein Polymer des Typs ii) oder iii), vorallem Homo-und Copolymere von Styrol oder Hydroxystyrolen. Ganz besonders bevorzugt sind handelsübliche Poly(p-hydroxystyrole) und Polystyrole. Diese weisen im allgemeinen ein Molekulargewicht (Mw) von 1'000 bis 100'000, besonders von 4'000 bis 25'000, gemessen mittels Gelpermeationschromatographie, auf.

Als Säure- oder Radikalbildner b), die unterder Einwirkung von Strahlung eine Säure oder Radikale bilden, kommen z.B. in Frage:
Säurebildner, die bei der Bestrahlung Säuren mit einem pka kleiner als 2 bilden, wie Oniumsalze, wie Diazonium-, Sulfonium-, Sulfoxonium- und lodoniumsalze.

Bevorzugt sind Sulfoniumsalze der Formel 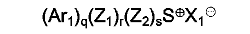 worin
Ar₁ unsubstituiertes oder durch Halogen, C₁-C₄-Alkyl, C₁-C₄-Alkoxy, -OH und/oder Nitro substituiertes Phenyl, Naphthyl oder Phenyl-COCH₂- ist,
Z₁ C₁-C₆-Alkyl oder C₃-C₇-Cycloalkyl und
Z₂ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
X₁ ein Chlorid-, Bromid- oder lodidanion, BF₄⁸, PF,AsF₆, SbF₆, FSO° oder das Anion einerorganischen Sulfonsäure oder Carbonsäure ist.

Phenyl-, Naphthyl- und Phenacylgruppen Ar₁ sind bevorzugt einfach substituiert, insbesondere durch Cl, Br, Methyl, Methoxy, -OH oder Nitro. Besonders bevorzugt sind diese Reste unsubstituiert. Z₁ ist vorzugsweise C₁-C₄-Alkyl, insbesondere Methyl oder Ethyl. Bevorzugt sind q 2 oder 3, r 1 oder Null und s Null, insbesondere ist q die Zahl 3, und r und s sind Null. Ganz besonders bevorzugt ist Ar₁ unsubstituiertes Phenyl und q ist 3.

Stellt X₁⁸ das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonders Fluor, Alkyl, wie Methyl, Ethyl oder n-Propyl, oder Alkoxy, wie Methoxy, Ethoxy oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher-10-sulfonsäure oder deren teil- oder perfluorierte Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalin-mono-, -di- oder-tri-sulfonsäuren und die entsprechenden alkylierten oderteil-oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, a-Methylbenzylsulfon- säure und die entsprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, a-Methylbenzylcarbonsäure und Zimtsäure, sowie die entsprechenden teil- oder perfluorierten Derivate dieser Verbindungen.

Vorzugsweise handelt es sich bei X₁⁸ um das einwertige Anion einer organischen Sulfonsäure, insbesondere einer teilfluorierten oder perfluorierten Sulfonsäure. Diese Anionen zeichnen sich durch eine besonders geringe Nucleophilie aus.

Bevorzugte Beispiele für geeignete Sulfoniumsalze sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydrothiopheniumchlorid, 4-Nitrophenacyltetrahydrothiopheniumchlorid und 4-Hydroxy-2-methylphenylhexahydrothiopyryliumchlorid. Besonders bevorzugt istTriphenylsulfoniumtrifluormethansulfonat.

Als Säurebildner können auch lodoniumsalze der Formel 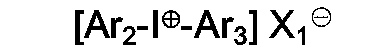
verwendet werden, worin

Ar₂ und Ar₃ unabhängig voneinander unsubstituiertes oder durch C₁-C₄-Alkyl, C₁-C₄-Alkoxy, Halogen und/oder Nitro substituiertes Phenyl oder Naphthyl sind oder Ar₂ oder Ar₃ zusammen eine Gruppe der Formel 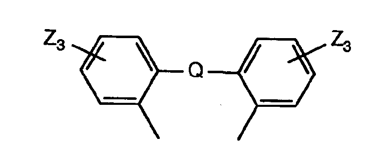
darstellen, worin Z₃ C₁-C₄-Alkyl, C₁-C₄-Alkoxy, Halogen oder Nitro und Q eine Direktbindung, -O-, -CH₂- oder -CO- darstellen und X₁ die angegebene Bedeutung hat. Als Säurebildner eignen sich auch unter Einwirkung von Strahlung Sulfonsäure erzeugende Substanzen der Formeln n 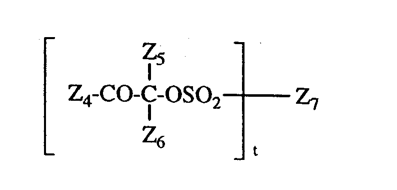 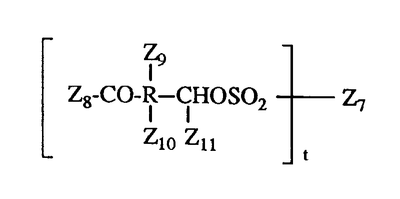 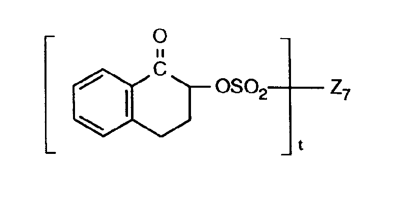 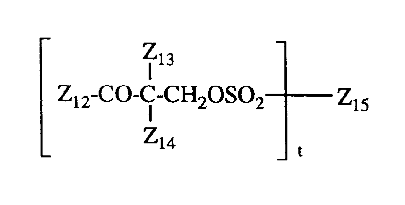 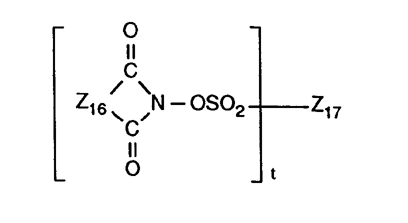 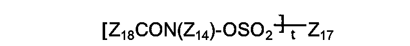
und 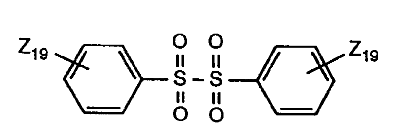
worin
t 1 oder 2, bevorzugt 1 ist,
Z₄ unsubstituiertes oder durch 1-3 -Cl, -Br, -CN, -NO₂, C₁-C₄-Alkyl, C₁-C₄-Alkoxy,
C₁-C₄-Alkylthio, Phenoxy, Phenylthio, C₁-C₄-Alkylamino, C₂-C₄-Dialkylamino oder benzoylsubstituiertes Phenyl oder Naphthyl, besonders unsubstituiertes oder einfach durch -Cl, Methyl oder Methoxy substituiertes Phenyl darstellt,
Z5 Wasserstoff oder C₁-C₄-Alkyl und
Z₆ Wasserstoff, C₁-C₄-Alkyl oder Phenyl bedeuten oder
Z5 und Z₆ zusammen mit dem Bindungs-C-Atom einen Cyclopentan- oder Cyclohexanring bilden,
Z₇, bei t = 1, C₁-C₁₈-Alkyl, unsubstituiertes oder durch C₁-C₄-Alkyl substituiertes Phenyl oder Naphthyl, Cyclopentyl, Cyclohexyl oder Campheryl und bei t = 2 C₂-C₈-Alkylen oder Phenylen bedeutet,
Z₈ unsubstituiertes oder durch 1-3 -CI, -Br, C₁-C₄-Alkyl, C₁-C₄-Alkoxy, C₁-C₄-Alkylthio, Phenyl, Phenoxy, Phenylthio, C₁-C₄-Alkyl-CONH-, Benzoylamino, Dimethylamino substituiertes Phenyl oder Naphthyl, besonders unsubstituiertes oder einfach durch -CI,
C₁-C₄-Alkoxy, Methylthio oder Phenyl substituiertes Phenyl ist,
Z₉ -OH oder C₁-C₄-Alkyl ist,
Z₁₀ C₁-C₄-Alkyl oder Phenyl ist,
Z₁₁ Wasserstoff, C₁-C₄-Alkyl, Furyl oder-CCl₃ bedeutet oder
Z₁₀ und Z₁₁ zusammen mit dem Bindungs-C-Atom einen Cyclopentan- oder Cyclohexanring bilden,
Z₁₂ und Z₁₃ unabhängig voneinander unsubstituiertes oder durch Halogen, C₁-C₄-Alkyl oder C₁-C₄-Alkoxy substituiertes Phenyl sind,
Z₁₄ Wasserstoff oder C₁-C₄-Alkyl darstellt,
Z₁₅ bei t = 1, C₁-C₆-Alkyl, Phenyl, Naphthyl oder Benzyl und bei t 2 C₁-C₆-Alkylen, Phenylen oder Xylylen darstellt,
Z₁₆ unsubstituiertes oder durch Halogen, Nitro, C₁-C₄-Alkyl, C₁-C₄-Alkoxy oder C₁-C₄-Alkylthio substituiertes Phenylen oder Naphthylen oder -CH=CH- ist,
Z₁₇ bei t = 1 C₁-C₁₂-Alkyl, unsubstituiertes oder durch Halogen, Nitro, C₁-C₄-Alkyl oder C₁-C₄-Alkoxy substituiertes Phenyl und bei t = 2 C₂-C₈-Alkylen oder Phenylen ist,
Z₁₈ unsubstituiertes oder durch Halogen, Nitro, -CN, C₁-C₄-Alkyl, Methoxy, Ethoxy, Dimethylamino oder Benzoyl substituiertes Phenyl oder Naphthyl bedeutet und die Z₁₉ unabhängig voneinander C₁-C₄-Alkyl sind.

Definitionsgemässe Alkyl-, Alkoxy-, Alkylthio-, Alkylamino-, Dialkylamino-, Alkylcarbamoyl- und Alkylengruppen können geradkettig oder verzweigt sein, sind aber bevorzugt geradkettig. Halogen bedeutet insbesondere -CI oder-Br.

Verbindungen dieser genannten Formeln sind z.B. in den EP-A 0 166 682 und 0 085 024 sowie der darin zitierten Literatur beschrieben. Besonders bevorzugte Verbindungen sind Phenacyl-p-methylbenzolsulfonat, Benzoin-p-toluolsulfonat, 3-(p-Toluolsulfonyloxy)-2-hydroxy-2-phenyl-1-phenyl-1-propanon [a-(p-Toluolsulfo- nyloxy)methylbenzoin], N-(p-Dodecylbenzolsulfonyloxy)-1,8-naphthalimid und N-(Phenylsulfonyloxy)1,8-naphthalimid.

Weitere geeignete Säurebildnersind o-Nitrobenzaldehyde, die sich unter Bestrahlung in o-Nitrosobenzoesäuren umlagern, wie 2-Nitrobenzaldehyd und 2,6-Dinitrobenzaldehyd; a-Halogenacylphenone, wie a,a,a-Tri- chloracetophenon und p-tert.Butyl-a,a,a-trichloracetophenon, sowie Sulfonsäureestervon o-Hydroxyacylphenonen, wie 2-Hydroxybenzophenonmethansulfonat und 2,4-Hydroxybenzophenon-bis-(methansulfonat).

Schliesslich eignen sich als Säurebildner auch solche, die aromatisch gebundenes Chlor oder Brom enthalten, wie sie beispielsweise in der EP-A 0 318 649 beschrieben sind, z.B. Verbindungen der Formel

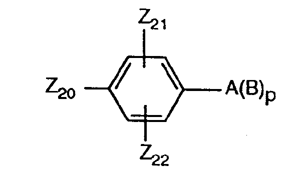

mit mindestens einem aromatisch gebundenen Chlor- oder Bromatom, worin z.B.
p 0 oder 1 bedeutet,
Z₂₀ -COOH, -OZ₂₃ oder -SZ₂₃ ist,
Z₂₁ und Z₂₂ unabhängig voneinander Wasserstoff, -CI, -Br, gegebenenfalls durch Aryl, Alkoxy, Aryloxy, -OH oder -F substituiertes Alkyl oder gegebenenfalls durch Alkoxy, Aryloxy, -OH oder Halogen substituiertes Aryl sind,
Z₂₃ Wasserstoff, gegebenenfalls analog Z₂₁ substituiertes Alkyl oder Aryl oder Acyl ist, A bei p =0, Wasserstoff,
-CI, -Br, gegebenenfalls analog zu Z₂₁ substituiertes Alkyl und bei p = 1, -SO₂-, Propylen oder Perfluoralkylen ist und B eine Gruppe

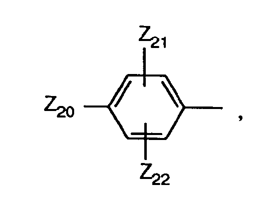

Alkylcarbonyl, Alkoxycarbonyl oder substituiertes Sulfonylimidocarbonyl bedeutet.

Beispiele derartiger Verbindungen sind Hexafluortetrabrom-Bisphenol A, 1,1,1-Tris-(3,5-dibrom-4-hydroxyphenyl)ethan und N-(2,4,6-Tribromphenyl)-N'-(p-toluolsulfonyl)harnstoff.

Die Säurebildner werden zweckmässig in einer Menge von 0,1-20 Gew.-%, vorzugsweise 1-10 Gew.-% und insbesondere 1-6 Gew.-%, bezogen auf das Gewicht des Matrix Polymers, eingesetzt.

Geeignete Radikalbildner, die in der Resistlösung vorhanden sein können, sind z.B. bekannte Photoinitiatoren, wie Benzoine und Benzoinether, z.B. Benzoin, Benzoinmethylether, Benzoinethylether und Benzoinisopropylether, Benzoinphenylether und Benzoinacetat; Acetophenone, wie Acetophenon, 2,2-Dimethoxyacetophenon und 1,1-Dichloracetophenon; Benzil, Benzilketale, wie Benzildimethylketal und Benzildiethylketal; Anthrachinone, wie 2-Methylanthrachinon, 2-Ethylanthrachinon, 2-tert.-Butylanthrachinon, 1-Chloranthrachinon und 2-Amylanthrachinon; Triphenylphosphin; Benzoylphosphinoxide, wie beispielsweise 2,4,6-Trimethylbenzoyldiphenylphosphinoxid (Luzirin TPO); Benzophenone, wie Benzophenon und 4,4'-Bis-(N,N'-dimethylamino)-benzophenon; Thioxanthone und Xanthone; Acridinderivate; Phenazinderivate; Quinoxalinderivate oder 1-Phenyl-1,2-propandion-2-O-benzoyloxim; 1-Aminophenylketone oder 1-Hydroxyphenylketone, wie 1-Hydroxycyclohexylphenylketon, Phenyl-(1-hydroxyisopropyl)-keton und 4-lsopropylphe- nyl-(1-hydroxyisopropyl)-keton.

Geeignet sind auch Elektronentransfer-Initiatoren vom Typ der Xanthone, wie beispielsweise 2,4,5,7-Tetraiodo-6-hydroxy-9-cyano-3H-xanthen-3-on, die zusammen mit geeigneten Elektronendonatoren im sichtbaren Bereich des Spektrums eine hohe Reaktivität aufweisen.

Eine weitere Klasse von geeigneten Photoinitiatoren stellen die ionischen Farbstoff-Gegenionverbindungen (ionic dye-counter ion compound) dar, welche in der Lage sind, Strahlen zu absorbieren und freie Radikale zu erzeugen, die die Polymerisation der ätzbarrierebildenden Substanz initiieren. Die erfindungsgemässen Gemische, welche ionische Farbstoff-Gegenionverbindungen enthalten, können auf diese Weise mit sichtbarem Licht im einstellbaren Wellenlängenbereich von 400-700 nm variabler gehärtet werden. lonische Farbstoff-Gegenionverbindungen und deren Wirkungsweise sind bekannt, beispielsweise aus der EP-A-O 223 587 und den US-Patenten 4,751,102; 4,772,530 und 4,772,541. Als Beispiele für geeignete ionische Farbstoff-Gegenionverbindungen seien genannt: die anionischen Farbstoff-lodoniumionkomplexe, die anionischen Farbstoff-Pyrylliumionkomplexe und insbesondere die kationischen Farbstoff-Boratanionverbindungen der folgenden Formel 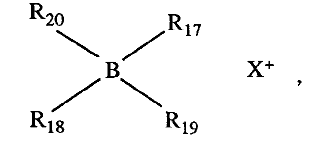
worin X⁺ für einen kationischen Farbstoff steht und R₁₇, R,₈, R₁₉ und R₂₀ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten.

Besonders geeignete Photoinitiatoren, welche gewöhnlich in Kombination mit einem HeCd-Laser als Strahlenquelle verwendet werden, sind Acetophenone, wie 2,2-Dialkoxybenzophenone, und a-Hydroxy-phenylketone, beispielsweise 1-Hydroxycyclohexylphenylketon oder (2-Hydroxyisopropyl)-phenylketon (= 2-Hydroxy-2,2-dimethylacetophenon).

Ein besonders bevorzugter Photoinitiator ist 1-Hydroxycyclohexylphenylketon.

All diese Säure- und Radikalbildner Komponenten b) sind bekannt und können nach bekannter Art und Weise hergestellt werden. Gemische von Säure- und Radikalbildner können auch eingesetzt werden.

Aetzbarrierebildende Substanzen c) sind metallhaltige (z.B. Aluminium, Gallium, Germanium, Indium, Zinn, Titan, Chrom, Mangan, Eisen, Nickel, Kupfer, Ruthenium und vor allem Silizium) polymerisationsfähige Monomere, die teils bekannte Substanzen sind, wie organometallische Verbindungen, wie siliziumhaltige Epoxide oder siliziumhaltige (Meth)acrylate oder vor allem neue metallhaltige Vinylether, insbesondere Disiloxanvinyletherverbindungen.

All diese Substanzen c) müssen leicht säurekatalytisch bzw. radikalisch polymerisierbar sein, und eine genügende Flüchtigkeit aufweisen, damit diese Substanzen beim Wärmeschritt die Oberfläche des Resistfilms verlassen können.

Die neuen Disiloxanvinyletherverbindungen, welche für das erfindungsgemässe Verfahren und vor allem in der neuen Resistlösung besonders geeignet sind, entsprechen der Formel 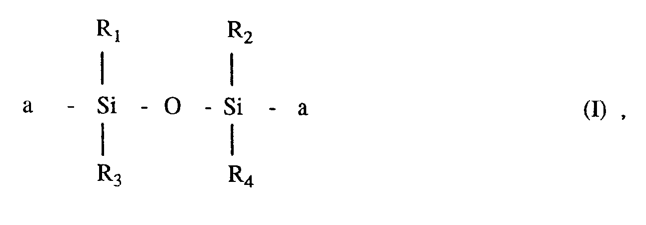
worin
a eine Gruppe der Formel (11) 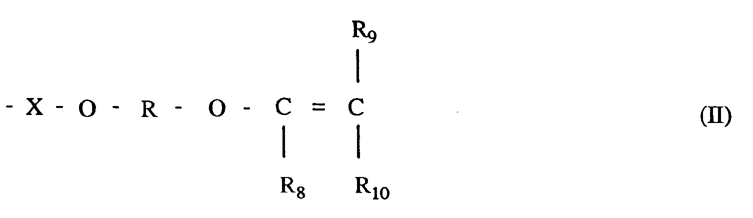
   ist,
R₁, R₂, R₃ und R₄ unabhängig voneinander C₁-C₆-Alkyl, sowohl gerade als auch verzweigt, C₃-C₆-Cycloalkyl, Aryl oder OSi(R₅)₃, vor allem aber C₁-C₆-Alkyl, Phenyl, Naphthyl, Diphenyl oder OSi(R₅)₃ bedeuten,
R₈, Rg und R₁₀ unabhängig voneinander Wasserstoff oder C₁-C₄-Alkyl, vor allem Wasserstoff oder CH₃ sind, R₅ C₁-C₃-Alkyl, vor allem CH₃,
X eine direkte Bindung oder [C(R₆)_{2]n},
R₆ Wasserstoff, C₁-C₃-Alkyl oder Phenyl, vor allem Wasserstoff,
n eine ganze Zahl von 1 bis 5, vor allem von 1 bis 3,
R [C(R₇)₂]ₘ,
m eine ganze Zahl von 1 bis 10, vor allem von 1 bis 8, und
R₇ Wasserstoff oder C₁-C₃-Alkyl, vor allem Wasserstoff oder CH₃ bedeuten.

Beispiele für ätzbarrierebildende Substanzen c) sind Acryloxysilane und Methacryloxysilane, wie z.B. Bis(acryloxymethyl)-dimethylsilan, Bis(acryloxymethyl)-methylphenylsilan, Bis(methacryloxymethyl)-dimethylsilan, -diethylsilan und -methylphenylsilan, Diacryloxy-methylphenylsilan, -dimethylsilan und -diethylsilan, Dimethacryloxy-methylphenylsilan, -dimethylsilan und -diethylsilan, Bis(methacryloxymethyl)-tetrame- thyldisiloxan, Bis(acryloxymethyl)-tetramethyldisiloxan, Bis(2,7-dioxaoct-8-enyl)-tetramethyldisiloxan, Bis-(1,6-dioxaoct-7-enyl)-tetramethyldisiloxan, 1,6-Dioxaoct-7-enyl-trimethylsilan, Bis(3-glycidoxypropyl)-tetramethyl-disiloxan, 1,1,1,5,5,5-Hexamethyl-3-[2-(7-oxabicyclo[4.1.0]-hept-3-yl)ethyl]-3-[(trimethylsilyl)oxy]-tri- siloxan, Epoxyd von 4,4'-Bis(trimethylsilyloxymethyl)-1-cyclohexen.

Die Wahl des Lösungsmittels gemäss der Komponente d) der Resistlösung, worin die Komponenten a), b) und c) gelöst sind, und die Konzentration richten sich hauptsächlich nach der Art der Zusammensetzung der Resistlösung und nach dem Beschichtungsverfahren. Das Lösungsmittel soll inert sein, d.h. es soll mit den Komponenten a), b) und c) keine chemische Reaktion eingehen und es soll bei der Trocknung nach dem Beschichten wieder entfernt werden können. Geeignete Lösungmittel sind z.B. Ketone, Ether oder Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester, 3-Ethoxypropionsäureethylester, Diethylenglykoldimethylether und 1-Methoxy-2-propylacetat.

Als gegebenenfalls weitere Zusatzstoffe e) kommen z.B. in Frage: Absorber, Filmbildner, Sensibilisatoren, Bindemittel, Stabilisatoren, Pigmente, Farbstoffe, Füllstoffe, Haftvermittler, Verlaufmittel, Netzmittel und Weichmacher.

Die Resistlösung wird mittels bekannter Beschichtungsverfahren bei Raumtemperatur gleichförmig auf das Substrat aufgebracht, z.B. durch Tauchen, Rakelbeschichtung, Aufpinseln, Sprühen, speziell durch elektrostatisches Sprühen und Reverse-Rollbeschichtung und vorallem durch Aufschleudern, und anschliessend in einem Wärmeschritt z.B. bei 50-100°C, vorteilhaft bei 75-80°C während 30 Sekunden bis 2 Minuten, vor allem 60 Sekunden, getrocknet, um das Lösungsmittel zu verdampfen, wobei ein Resistfilm auf dem Substrat resultiert. Es ist auch möglich, die lichtempfindliche Schicht auf einen temporären, flexiblen Träger zu bringen und dann durch Schichtübertragung via Laminierung das endgültige Substrat, z.B. eine kupferkaschierte Leiterplatte, zu beschichten.

Der auf dem Substrat mittels der Resistlösung gebildete Resistfilm muss die Eigenschaften aufweisen, dass er homogen und stark absorbierend ist; die optische Dichte liegt vorallem im Bereich von 0,1-2,5 und insbesondere bei 1,5-2,5. Seine Dicke beträgt etwa 0,3 bis 10 wm, vor allem 1 f..lm.

Das Gewichtsverhältnis der Komponenten a): b): c) liegt vorteilhaft im Bereich von 10:0,1 bis 2,0:1 bis 3 und insbesondere im Bereich von 10:0,5:2.

Das Substrat ist vorzugsweise eine Scheibe (wafer) aus insbesondere monokristallinen Materialien, wie Silizium, Aluminium, Galliumarsenid oder Siliziumoxid.

Das erfindungsgemässe Verfahren beruht nun im einzelnen darauf, dass durch Einwirkung energetischer Strahlung an der Oberfläche des hochabsorbierenden Resistfilms ein chemischer Filter in Form von freier Broenstedsäure bzw. Radikalen gebildet wird. Dabei wird die ätzbarrierebildende Substanz an der Oberfläche der belichteten Zonen des Resistfilms angereichert, d.h. seine Konzentration wird gegenüber derjenigen im ursprünglichen, unbelichteten Resistfilm erhöht.

Nach der Belichtung wird das System (Resistfilm und Substrat) auf eine Temperatur von etwa 100°C bis 170°C während etwa 30 Sekunden bis 15 Minuten, vorteilhaft auf 100°C bis 125°C während 3 Minuten, die im Bereich des Glasumwandlungspunktes des Matrix Polymeren liegt, geheizt; dadurch diffundiert das polymerisierbare Monomer der ätzbarrierebildenden Substanz c) an die Oberfläche des Resistfilms, wobei diese Substanz c) auf die photolytisch freigesetzte polymerisationsauslösende Species, den Radikal oder die Säure der Komponente b), trifft und an den belichteten Stellen des Resistfilms unter Vergrösserung des Molekulargewichtes ein Oligomer bildet, welches dann aus der Filmoberfläche nicht hinausdiffundieren kann, während an den durch die Maske abgedeckten Stellen (unbelichtete Zonen des Resistfilms) ein Austritt der Komponente c) aus der Filmoberfläche möglich ist, da keine freie Säure bzw. Radikale erzeugt wurden und das Monomer somit den Resistfilm ungehindert verlassen kann. Dies äussert sich nach dem Wärmeschritt durch eine Abnahme der Filmdicke an den unbelichteten Zonen des Resistfilms, während an den belichteten Zonen die ursprüngliche Dicke erhalten bleibt. Durch diese Oligomerbildung resultiert eine Metallanreicherung an der Resistfilmoberfläche, welche somit eine Aetzbarriere darstellt, die der Erzeugung von Mikrostrukturen dient.

Die Belichtung des Resistfilms erfolgt mit Licht einer Wellenlänge zwischen etwa 180 und 1000 µm, vor allem einer UV-Bestrahlung, insbesondere einer Tief-UV-Bestrahlung im Bereich von etwa 190 bis 280 Nanometer, vor allem bei 193 oder 248 Nanometer mit einem Excimerlaser oder mittels einer Quecksilberdampflampe durch eine Maske.

Als Maske kommen die verschiedensten Substanzen zurAnwendung; bevorzugt wird eine Die Entwicklung des belichteten Resistfilms erfolgt vorzugsweise durch ein gerichtetes Sauerstoffplasma, wodurch der Resistfilm an den unbelichteten Stellen entfernt wird und die Maskenstruktur an den belichteten Stellen des Substrats getreu übertragen wird. Dabei können Maskenstrukturen im Micrometerbereich, in etwa 0,1 bis 10 µm, hergestellt werden.

Verwendung finden die gemäss dem erfindungsgemässen Verfahren erhaltenen Mikrostrukturen in der Mikrolithographie sowie auf dem Elektronik-Sektor, vor allem zur Herstellung höchstintegrierter Halbleiterbausteine, insbesondere Speicherchips (DRAM's), ferner in der Mikroelektronik zur Herstellung von integrierten Schaltkreisen und Leiterplatten. Die Integrationsdichte wird im Wesentlichen vom Auflösungsvermögen des Photoresistmaterials bestimmt, d.h. wie eng nebeneinander letztendlich die einzelnen Leiterbahnen des elektronischen Bausteins gelegt werden können. Ein Photoresist muss in der Lage sein, die Strukturen einer Maske originalgetreu auf das darunterliegende Substrat zu übertragen unter Einhaltung der geforderten physikalischen und chemischen Rahmenbedingungen, wie z.B. thermische Stabilität, Aetzstabilität, Wandprofile u.a.m.

Die folgenden Beispiele veranschaulichen die Erfindung, dienen illustrativen Zwecken, ohne sie darauf zu limitieren.

### A) Herstellungsbeispiele

### Beispiel 1: Bis(acryloxymethyl)dimethylsilan

In einem 1,5 Liter Sulfierkolben werden 600 ml Diethylether vorgelegt, dann werden 51,0 g (425 mMol) Bis(hydroxymethyl)dimethylsilan und 76,9 g (850 mMol) Acrylsäurechlorid darin gelöst. Danach werden bei 10°C langsam 86,0 g (850 mMol) Triethylamin zugetropft. Man lässt während 2 Stunden ausreagieren, filtriert den entstandenen Niederschlag ab und engt ein. Das resultierende Oel wird bei 74°C/0,1 mbar destilliert. Dabei werden 30,5 g (13,4 mMol; 31 %) der gewünschten Verbindung als klares Oel erhalten. ¹H]-NMR (300 MHz, CDCI3): d 6,38/dd/2H; 6,12/dd/2H; 5,82/dd/2H; 3,96/s/4H; 0,17/s/6H.

### Beispiel 2: Dimethacryloxymethylphenylsilan

In einem 350 ml Sulfierkolben werden zu einer Lösung von 16,2 g (160 mMol) Triethylamin in 300 ml Diethylether (nachstehend als Ether bezeichnet) langsam 17,7 g amin in 300 ml Diethylether (nachstehend als Ether bezeichnet) langsam 17,7 g (160 mMol) Methacrylsäure getropft. Anschliessend gibt man langsam 17,2 g (90 mMol) Methylphenyldichlorsilan zu, lässtwährend 24 Stunden bei Raumtemperatur ausreagieren, filtriert und engt ein. Das zurückbleibende Oel wird bei 90°C/0,07 mbar destilliert, wobei 17,6 g (61 mMol; 67%) des gewünschten Produkts erhalten werden. ¹H-NMR (300 MHz, CDCI3): d 7,77/m/2H; 7,46/m/3H; 6,24/d/2H; 5,68/d/2H; 1,94/s/6H; 0,88/s/3H.

### Beispiel 3: Diacryloxymethylphenylsilan

In einem 350 ml Sulfierkolben wird das gewünschte Produkt analog Beispiel 2 aus 11,61 g (90 mMol) Methylphenyldichlorsilan, 11,53 g (160 mMol) Acrylsäure und 16,2 g (160 mMol) Triethylamin, gelöst in 250 ml Diethylether, nach Destillation bei 31°C/0,3 mbar in einer Ausbeute von 3,83 g (19 mMol; 21%) erhalten. ¹H-NMR (300 MHz, CDCI3): d 6,43/dd/2H; 6,11/dd/2H; 5,92/dd/2H; 0,58/s/6H.

### Beispiel 4: Dimethacryloxydimethylsilan

Die Substanz wird in einem 500 ml Sulfierkolben mit mechanischem Rührwerk analog Beispiel 2 aus 11,5 g (90 mMol) Dimethyldichlorsilan, 13,77 g (160 mMol) Methacrylsäure und 16,2 g (160 mMol) Triethylamin, gelöst in 250 ml Diethylether, hergestellt. Nach Destillation bei 45°C/0,3 mbar werden 12,92 g (57 mMol; 63%) des gewünschten Produkts erhalten. ¹H-NMR (300 MHz, CDCI3): d 5,96/d/2H; 5,44/d/2H; 1,71/s/6H; 0,35/s/6H.

### Beispiel 5: Dimethacryloxydiethylsilan

In einem 350 ml Sulfierkolben wird die gewünschte Substanz analog Beispiel 2 aus 12,0 g (76 mMol) Diethyldichlorsilan, 11,7 g (136 mMol) Methacrylsäure und 13,7 g (136 mMol) Triethylamin, gelöst in 220 ml Diethylether, durch Destillation bei 55°C/0,09 mbar in einer Ausbeute von 8,16 g (32 mMol; 42%) erhalten. ¹H-NMR (300 MHz, CDCI3): d 6,19/d/2H; 5,66/d/2H; 1,94/s/6H; 1,04/m/10H.

### Beispiel 6: Bis(chloromethyl)tetramethyldisiloxan

In einem 750 ml Sulfierkolben werden 62 g (0,5 Mol) Chlormethyltrimethylsilan mit200 g konzentrierter Schwefelsäure versetzt. Man lässt während 30 Minuten bei 82°C reagieren, bevor zweimal mit je 150 ml Diethylether extrahiert wird. Die vereinten Etherextrakte werden mit einer 5%-igen wässrigen Natriumhydrogenkarbonatlösung gewaschen, über Magnesiumsulfat getrocknet und eingeengt. Das resultierende Rohprodukt wird anschliessend am Wasserstrahlvakuum destillativ gereinigt. Siedepunkt: 105°C/30 mbar. Ausbeute: 48,9 g (21 mMol; 85%). ¹H-NMR (300 MHz, CDCI3): d 2,74/s/4H; 0,22/s/12H.

### Beispiel 7: Bis(methacryloxymethyl)tetramethyldisiloxan

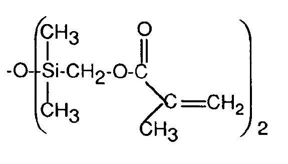

In einem 100 ml Rundkolben wird eine Lösung von 21,5 g (250 mMol) Methacrylsäure und 1,0 g Hydrochinon unter Rückfluss langsam mit 11,9 g (110mMol) Natriummethacrylat und danach mit 11,6 g (50 mMol) des gemäss Beispiel 6 erhaltenen Diloxans versetzt. Man rückflussiert während 75 Min., lässt abkühlen und wäscht das erhaltene Produkt zweimal mit je 100 ml Wasser und danach zweimal mit je 100 ml 5%-iger wässriger Natriumhydrogencarbonatlösung. Schliesslich wird über Magnesiumsulfat getrocknet, eingeengt, und das erhaltene Rohprodukt wird bei 100°C/0,18 mbar destillativ gereinigt. Dabei werden 11,52 g (36 mMol; 70%) des Produktes als klares Oel, erhalten.

¹H-NMR (300 MHz, CDCI3): d 5,90/d/2H; 5,36/d/2H; 3,61/s/4H; 1,77/s/6H, 0,00/s/12H.

### Beispiel 8: Bis(acryloxymethyl)tetramethyldisiloxan

Analog Beispiel 7 werden aus 18,0 g (250 mMol) Acrylsäure, 1,0 g Hydrochinon, 10,3 g (110mMol) Natriumacrylat und 11,6 g (50 mMol) des gemäss Beispiel 6 erhaltenen Disiloxans, 2,05 g (6,8 mMol; 14%) des gewünschten Produkts mit einem Siedepunkt von 70°C/0,05 mbar als klare Flüssigkeit erhalten.

¹H-NMR (300 MHz, CDCI3): d 6,19/dd/2H; 5,96/dd/2H; 5,63/dd/2H; 3,64/s/4H, 0,00/s/12H.

### Beispiel 9: Copolymer von p-Hydroxyphenylmaleinimid und Methylmethacrylat

In einem 250 ml Rundkolben werden in 90 ml Tetrahydrofuran 14,2 g (75 mMol) p-Hydroxyphenylmaleinimid, 7,51 g (75 mMol) Methylmethacrylat und 0,87 g Dibenzoylperoxid gelöst. Man lässt während 4 Std. bei 60°C reagieren und fällt das erhaltene Produkt anschliessend durch Zugabe von 400 ml n-Hexan. Dabei werden 16,22 g (74,8%) eines gelblichen Pulvers oben angegebenen Produktes erhalten.

### GPC (Polystyrol-Eichung): Mw=4300, Mn=405

### DSC (10°C/Min): Tg=141°C.

### Beispiel 10: Copolymervon Styrol und N-Ethylmaleinimid

In einem 50 ml 2-Halsrundkolben werden 2,1 g (20 mMol) Styrol, 2,5 g (20 mMol) N-Ethylmaleinimid und 140 mg Azoisobutyronitril in 18 g Toluol gelöst. Man lässt während 3 Std. bei 70°C reagieren und fällt das Produkt anschliessend aus 300 ml Methanol. Nach dem Trocknen werden 4,0 g (87%) eines weissen Pulvers des oben angegebenen Produktes erhalten.

¹H-NMR (300 MHz, CDCI3): d 7,5-6,0/m/5H; 3,6-3,1/m/2H; 3,0-1,5/m/5H; 1,2-0,7/m/3H.

### DSC (10°C/Min): Tg=173°C.

### GPC (Polystyrol-Eichung): Mn=25800, Mw=138700.

### Beispiel 11: Bis(2,7-dioxaoct-8-enyl)tetramethyldisiloxan

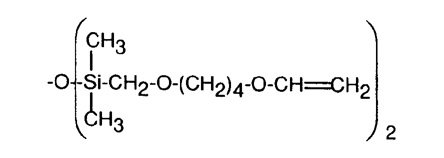

In einem 250 ml Rundkolben werden 11,6g (50 mMol) Bis(chlormethyl)tetramethyldisiloxan, 11,6 g (100 mMol) 4-Hydroxybutylvinyl-ether und 1,0 g Benzyltrimethylammoniumchlorid mit 100 ml 1 N Natronlauge versetzt und während 3 Stunden unter Rückfluss gekocht. Danach lässt man auf Raumtemperatur abkühlen, extrahiert zweimal mit je 100 ml Ether, trocknet die vereinigten Diethyletherphasen über Magnesiumsulfat und engt ein. Dabei werden 14,2 g eines farblosen Oels obiger chemischer Struktur erhalten, welches ohne weitere Reinigung weiterverwendet wird. ¹H-NMR (60 MHz, CDCI3): d 6,38/dd/2H; 4,10/dd/2H; 3,91/dd/2H; 3,61/m/8H, 2,33/s/4H; 1,62/m/8H; 0,0/s/12H.

### Beispiel 12: Bis(1,6-dioxaoct-7-enyl)tetramethyldisiloxan

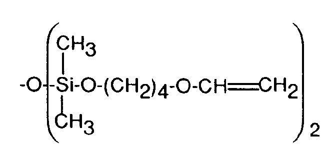

In einem 150 ml Rundkolben werden 5,0 g (43 mMol) 4-Hydroxybutylvinylether und 6,9 g (43 mMol) Hexamethyldisilazan in 50 ml Ether gelöst und bei Raumtemperatur langsam mit 4,4 g (21,5 mMol) 1,3-Dichlorotetramethyldisiloxan versetzt. Man lässt über Nacht bei Raumtemperatur ausreagieren und giesst danach auf 100 ml Wasser. Die organische Phase wird abgetrennt, über Magnesiumsulfat getrocknet und schliesslich am Hochvakuum eingeengt. Dabei werden 1,8 g (3,5 mMol; 16%) der oben angegebenen chemischen Verbindung als farbloses Oel erhalten. ¹H-NMR (300 MHz, CDCI3): d 6,35/dd/2H; 4,05/dd/2H; 3,87/dd/2H; 3,57/m/8H, 1,59/m/8H; 0,00/s/12H.

### Beispiel 13: 1,6-Dioxaoct-7-enyltrimethylsilan

### (H₃C)₃Si-O(CH₂)₄OCH=CH₂

In einem 150 ml Rundkolben werden 5,0 g (43 mMol) 4-Hydroxybutylvinylether und 13,9 g (86 mMol) Hexamethyldisilazan in 50 ml Diethylether gelöst und bei Raumtemperatur langsam mit 9,35 g (86 mMol) Trimethylchlorosi lan versetzt. Man lässtwährend einer Stunde bei Raumtemperatur ausreagieren und extrahiert danach zweimal mit je 100 ml Wasser. Die organische Phase wird über Magnesiumsulfat getrocknet und am Hochvakuum eingeengt. Dabei werden 6,5 g (34 mMol; 80%) des Produkts als farbloses Oel erhalten. ¹H-NMR (300 MHz, CDCI3): d 6,34/dd/1 H; 4,04/dd/1 H; 3,85/dd/1 H; 3,60/t/2H, 3,50/t/2H; 1,55/m/4H; 0,00/s/9H.

### B) Anwendungsbeispiele

### Beispiel 14

Es wird eine Resistlösung durch Auflösung von 100 g Poly-p-hydroxystyrol (Mw=20'000), 20 g Bis(3-glycidox- ypropyl)tetramethyl-disiloxan (Lieferant Firma Petrarch), 10 g Diphenyliodoniumhexafluoroarsenat und 10 g 9-Methylanthracen in 500 g Cyclopentanon hergestellt. Die Lösung wird filtriert und bei 3000 Umdrehungen/Minute auf einen 3 Zoll Quarzwafer aufgeschleudert. Der nach dem Trocknen bei 80°C während 60 Sekunden auf einer Wärmeplatte erhaltene 1,0 µm dicke homogene Resistfilm weist eine optische Dichte von grösser 2,4 auf. Der Film wird mittels einer Quecksilberdampflampe der Marke Ushio (500 Watt) durch ein Interferenez-Engbandfilter (254 nm, Halb-Dimensionen haben, mit einer Dosis von 30 mJ/cm² bildmässig belichtet. Nach der Belichtung wird der beschichtete Wafer während drei Minuten auf der Wärmeplatte bei 125°C geheizt, wobei sich in den zuvor nicht belichteten Teilen ein Volumenschwund manifestiert. Danach wird der beschichtete Wafer in eine Plasmaätzapparaturder Firma Alcatel gebracht und mittels Sauerstoff während 6 Minuten (Druck = 600 mbar, Gasfluss = 40 cm³/Min., Leistung = 100 Watt) entwickelt. Die zuvor belichteten Zonen des Resistfilms bleiben zurück (Abbildung der Maskenstrukturen im Micrometerbereich), während die unbelichteten Stellen weggeätzt werden.

### Beispiel 14a

Ersetzt man Poly-p-hydroxystyrol gemäss Beispiel 14 durch eine entsprechende Menge eines handelsüblichen Novolackes und verfährt man analog dem Beispiel 14, so werden gleichgute Resultate erhalten.

### Beispiel 15

Durch Auflösen von 100 g des Copolymers gemäss Beispiel 9, 20 g Bis(3-glycidoxypropyl)tetramethyldisilo- xan, 10 g Triphenylsulfoniumhexafluoroantimonatund 2 g 9-Methylanthracen in 500 g Cyclopentanon wird eine Resistlösung bereitgestellt. Resistfilme davon werden analog Beispiel 14 hergestellt und mit einer Dosis von 20 mJ/cm² bildmässig belichtet. Nach der Belichtung wird während 3 Minuten bei 100°C geheizt und danach während 7,5 Minuten mittels Sauerstoff (800 mbar, 40 cm³/Min., 100 Watt) entwickelt.

### Beispiel 16

Durch Auflösen von 100 g des Copolymers gemäss Beispiel 10, 20 g Bis(3-glycidoxypropyl)tetramethyldisilo- xan, 10 g Diphenyliodoniumhexafluoroarsenat und 5 g 9-Methylanthracen in 500 g Cyclohexanon wird eine Resistlösung hergestellt, welche analog Beispiel 14 auf einen Siliziumwafer aufgeschleudert und nach dem Trocknen mit einer Dosis von 40 mJ/cm² bildmässig belichtet wird. Nach dem Entwickeln (600 mbar, 100 Watt, 40 cm³/Min., 7 Min.) bleiben die vorher belichteten Zonen zurück (Abbildung der Maskenstrukturen im Micrometerbereich), während die unbelichteten weggeätzt werden.

### Beispiel 17

Ein Film einer Resistlösung enthaltend 100 g Poly-p-hydroxystyrol, 25 g der Verbindung gemäss Beispiel 11, 10 g Diphenyliodoniumhexafluoroarsenat und 5 g 9-Methylanthracen, gelöst in 480 g Cyclohexanon, wird mit einer Dosis von 20 mJ/cm² bildmässig belichtet und im Sauerstoffplasma (480 mbar, 100 Watt, 40 cm³/Min., 6 Min.) entwickelt, wobei eine Abbildung der Maskenstrukturen im Micrometerbereich erhalten wird.

### Beispiel 18

Ein Film einer Resistlösung enthaltend 100 g des Copolymers gemäss Beispiel 10, 20 g der Substanz gemäss Beispiel 11, 10 g Diphenyliodoniumhexafluoroarsenat und 2 g 9-Methylanthracen, gelöst in 500 g Cyclopentanon, werden analog Beispiel 14 mit einer Dosis von 40 mJ/cm² bildmässig belichtet und anschliessend im Sauerstoffplasma (600 mbar, 100 Watt, 40 cm³/Min., 8 Min.) entwickelt, wobei die Maskenstrukturen im Micrometerbereich abgebildet werden.

### Beispiel 19: 1,1,1,5,5,5-Hexamethyl-3-[2-(7-oxabicyclo[4.1.0]hept-3-yl)- ethyl]-3-[(trimethylsilyl)oxy]-trisilo- xan

In einem 750 ml Sulfierkolben werden 74,0 g (660 mMol) Natriumtrimethylsilyanolat, gelöst in 600 ml Diethylether, mit 48,8 g (200 mMol) 4[2-(Trichlorosilyl)-ethyl]cyclohexene (der Firma Petrarch) versetzt. Man lässt während 90 Minuten bei Raumtemperatur ausreagieren, giesst danach auf Eis und trocknet die resultierende organische Phase über Magnesiumsulfat. Das nach dem Einengen resultierende Oel wird bei 0,09 mbar/93°C destillativ gereinigt. Dabei resultieren 38 g (94 mMol; 47 %) von 3-[2-(cyclohexen-1-yl)-ethyl]-1,1,1,5,5,5-hexamethyl-3-[(trimethylsilyl)oxy]-trisiloxane als farbloses Oel. 12,5 g (31 mMol) dieser Verbindung werden in einem 350 ml Rundkolben in 100 ml Dichlormethan gelöst und mit 9,8 g (100 mMol) Kaliumacetat versetzt. Zu dieser Lösung werden bei Raumtemperatur tropfenweise 11,8 g (62 mMol) einer 40 prozentigen Lösung von Peressigsäure zugegeben. Man lässt während 90 Minuten bei Raumtemperatur ausreagieren, giesst danach auf eine Lösung von 10,0 g Kalziumhydroxyd in 100 ml Dichlormethan und trocknet die organische Phase über Magnesiumsulfat. Das resultierende Oel wird destillativ bei 0,08 mbar/100°C gereinigt. Ausbeute 4,9 g (12 mMol; 38 %).

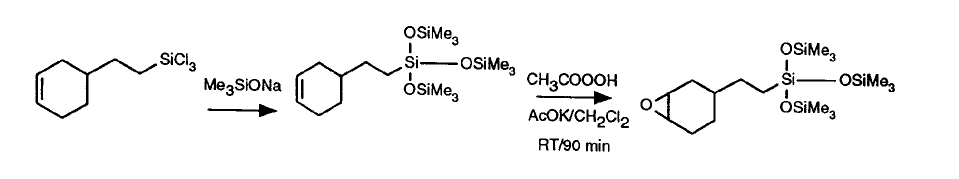

### Beispiel 20: Epoxid von 4,4'-Bis(trimethylsilyloxymethyl)-1-cyclohexen

In einem 1,5 Liter Sulfierkolben werden 35,5 g (250 mMol) 4,4'-Bis(hydroxymethyl)-1-cyclohexen (der Firma Petrarch) und 67,9 g (625 mMol) Trimethylchlorsilan in 550 ml cyclohexen (der Firma Petrarch) und 67,9 g (625 mMol) Trimethylchlorsilan in 550 ml Dichlormethan gelöst. Zu dieser Lösung werden bei Raumtemperatur 64,5 g (637 mMol) Triethylamin langsam zugetropft. Man lässt während 4 Stunden bei Raumtemperatur ausreagieren und giesst danach auf Eis. Die resultierende organische Phase wird mit 250 ml Wasser gewaschen, über Magnesiumsulfat getrocknet, eingeengt und bei 0,07 mbar/60°C destillativ gereinigt. Dabei resultieren 55,5 g (194 mMol; 78 %) von 4,4'-Bis(trimethylsi lyloxymethyl)-1-cyclohexen als farbloses Oel.

Davon werden 20 g (70 mMol) analog Beispiel 19 mit 26,8 g (140 mMol) 40 % Peressigsäure und 22,3 g (227 mMol) Kaliumacetat, gelöst in 200 ml Dichlormethan in das entsprechende Epoxid überführt. Die Reinigung erfolgt destillativ bei 0,1 mbar/72°C. Es resultieren 8,6 g (29 mMol; 41 %) des gewünschten Epoxids als farbloses Oel.

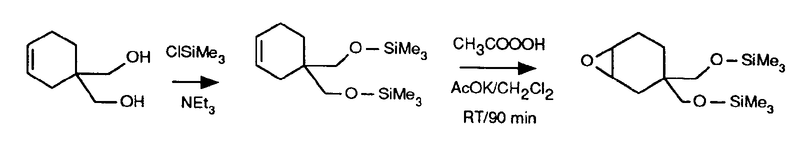

### Beispiel 21:

Es wird eine Resistlösung durch Auflösen von 80 Teilen Polystyrol (Mw=20'000), 20 Teilen des Epoxids aus obigem Beispiel 19, 10 Teilen Triphenylsulfoniumhexafluorarsenat und 5 Teilen 9-Methylanthracen in 400 Teilen Cyclopentanon hergestellt. Diese Lösung wird bei 6500 Umdrehungen auf einen 3 Zoll Siliziumwafer aufgeschleudert, wobei nach der Trocknung auf der Wärmeplatte bei 60°C während 1 Minute klare Resistfilme einer Dicke von 1,5 Mikrometer zurückbleiben. Diese Filme werden durch eine Chrom-Quarz Maske mit Licht der Wellenlänge von 254 nm (Dosis: 30 mJ/cm²) bildmässig belichtet. Danach wird auf der Wärmeplatte während 5 Minuten auf 120°C erhitzt, wobei eine Reliefstruktur an den unbelichteten Stellen erkennbar wird. Schliesslich wird in einem Sauerstoffplasma (900 mbar, 100 Watt, 40 cm³/Min) während 5 Minuten geätzt, wobei die vorher unbelichteten Zonen des Resistfilms abgetragen werden, die belichteten Zonen dagegen vollständig zurückbleiben (Abbildung der Maskenstrukturen im Micrometerbereich).

## Patentansprüche

1. Verfahren zur Herstellung von Mikrostrukturen auf einem Substrat durch Bildung eines Resistfilmes auf diesem Substrat und Belichtung des Resistfilmes durch eine Maske, dadurch gekennzeichnet, dass der Resistfilm eine ätzbarrierebildende Substanz enthält, welche bei der Belichtung an den belichteten Zonen des Resistfilms zum Aufbau eines Metall-Gradienten führt, und dass man anschliessend den beschichteten Resistfilm mit einem Sauerstoffplasma entwickelt, wobei die unbelichteten Stellen des Resistfilmes weggeätzt werden.

2. Verfahren gemäss Anspruch 1, dadurch gekennzeichnet, dass der Resistfilm auf dem Substrat durch Aufschleudern einer Resistlösung und anschliessende Trocknung erzeugt wird.

3. Verfahren gemäss Anspruch 2, dadurch gekennzeichnet, dass die Trocknung der Resistlösung bei 50°C bis 100°C während 30 Sekunden bis 2 Minuten erfolgt.

4. Verfahren gemäss Anspruch 2, dadurch gekennzeichnet, dass der Resistfilm eine optische Dichte von 0,1-2,5 aufweist.

5. Resistlösung gemäss Anspruch 2, dadurch gekennzeichnet, dass sie:
a) ein Matrix Polymer, das mindestens ein aromatisches Strukturelement aufweist,
b) eine unter aktinischer Strahlung Säure oder Radikale freisetzende Verbindung,
c) eine retardierbare ätzbarrierebildende Substanz,
d) ein Lösungsmittel, und
e) gegebenenfalls weitere Zusatzstoffe, enthält.

6. Resistlösung gemäss Anspruch 5, dadurch gekennzeichnet, dass die Komponenten a:b:c zueinander in einem Gewichtsverhältnis von 10:0,1-2,0:1-3 vorliegen.

7. Disiloxane der Formel 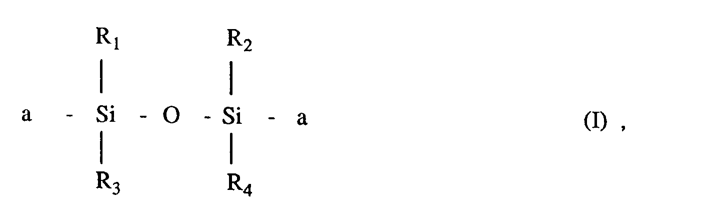
worin
a eine Gruppe der Formel (II) 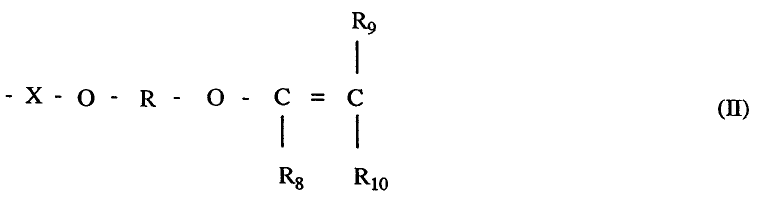
ist,
R₁, R₂, R₃ und R₄ unabhängig voneinander C₁-C₆-Alkyl, C₃-C₆-Cycloalkyl, Aryl oder OSi (R₅)₃ bedeuten, R₈, Rg und R₁₀ unabhängig voneinander Wasserstoff oder C₁-C₄-Alkyl,
R₅ C₁-C₃-Alkyl,
X eine direkte Bindung oder [C(R₆)₂]ₙ,
R₆ Wasserstoff, C₁-C₃-Alkyl oder Phenyl,
n eine ganze Zahl von 1 bis 5,
R [C(R₇)₂]ₘ,
m eine ganze Zahl von 1 bis 10, und
R₇ Wasserstoff oder C₁-C₃-Alkyl bedeuten.

8. Disiloxane gemäss Anspruch 7, dadurch gekennzeichnet, dass
R₁, R₂, R₃ und R₄ unabhängig voneinander C₁-C₆-Alkyl, Phenyl, Naphthyl, Diphenyl oder OSi (R₅)₃,
R₈, R₉ und R₁₀ Wasserstoff oder CH₃,
R₅ CH₃,
X eine direkte Bindung oder [C(R₆)₂]ₙ,
R₆ Wasserstoff,
n eine ganze Zahl von 1 bis 3,
R [C(R₇)₂]ₘ,
m eine ganze Zahl von 1 bis 8, und
R₇ Wasserstoff oder CH₃ bedeuten.

9. Resistlösung gemäss Anspruch 5, enthaltend als Komponente c) ein Disiloxan der Formel gemäss Anspruch 8.

10. Resistlösung gemäss Anspruch 5, enthaltend als Komponente a) ein Homo- oder Copolymer eines Alkenylphenols oder eines Styrols.

11. Resistlösung gemäss Anspruch 5, enthaltend als Komponente b) ein Sulfoniumsalz.

12. Verwendung der Resistlösung gemäss Anspruch 5 in der Mikrolithographie zur Herstellung von Halbleiterbausteinen und Speicherchips in der Mikroelektronik.
